# EUROPÄISCHE PATENTANMELDUNG

(11) **EP 0 792 094 A1**
(43) Veröffentlichungstag der Anmeldung: **27.08.1997**
(21) Anmeldenummer: 96117479.4
(22) Anmeldetag: 31.10.1996
(51) Int. Cl.: H05K 5/00

(54) **Elektronisches Steuergerät**

(30) Priorität: 24.02.1996 DE 29603390 U
(71) Anmelder: ROBERT BOSCH GMBH, 70442 Stuttgart (DE)
(72) Erfinder: Bentz, Willy, 74343 Sachsenheim (DE); Ernst, Waldemar, 71665 Vaihingen (DE)

(57) **Zusammenfassung**

Es wird ein elektronisches Steuergerät vorgeschlagen, das ein aus einem Boden (2) und einem Deckel (3) bestehendes Gehäuse (1) hat, in das eine Leiterplatte (7) eingesetzt ist.

Um die Leiterplatte (7) mit einer größtmöglichen Nutzungsfläche für die von ihr aufgenommenen elektronischen Bausteine (15 bis 19) auszustatten, ist sie einerseits durch eine Klebung mit dem Boden (2) verbunden und andererseits mittels einer schraublosen Klipsverbindung (8) mit einer steckerartigen Messerleiste (9) bestückt.

Das elektronische Steuergerät ist zur Nutzung in Kraftfahrzeugen bestimmt.

## Beschreibung

### Stand der Technik

Die Erfindung bezieht sich auf ein elektronisches Steuergerät nach der Gattung des Hauptanspruches. Ein derartiges Steuergerät ist bekannt (DE 33 10 477 A1).

Dieses bekannte Steuergerät hat ein quaderförmiges Gehäuse, dessen eine schmale Seitenwand eine steckerartige Messerleiste trägt. Die Messerleiste ist mit der Seitenwand verschraubt. Eine solche Schraubverbindung ist umständlich und teuer. Außerdem ist die Leiterplatte durch ihren seitlichen Einschub in das Gehäuse beschädigungsgefährdet und ihre Bestückungsfläche ist nicht optimal ausnutzbar.

Der Erfindung liegt die Aufgabe zugrunde, diese Nachteile zu vermeiden und ein elektronisches Steuergerät zu schaffen, dessen Gehäusekonzept bezüglich einer maximalen Bestückungs- und Schaltungsfläche der Leiterplatte ein Optimum darstellt.

Diese Aufgabe wird gemäß der Erfindung gelöst durch die kennzeichnenden Merkmale des Hauptanspruches.

Vorteilhafte Weiterbildungen des Gegenstandes des Anspruchs 1 ergeben sich aus den Merkmalen der Unteransprüche. So ist es gemäß den Ansprüchen 3 und 4 vorteilhaft, daß die Messerleiste mit der Leiterplatte nicht verschraubt, sondern daß sie lediglich gesteckt ist. Damit kann ein Montagevorgang vereinfacht werden. Arbeitszeit, Material und Kosten werden gespart.

### Zeichnung

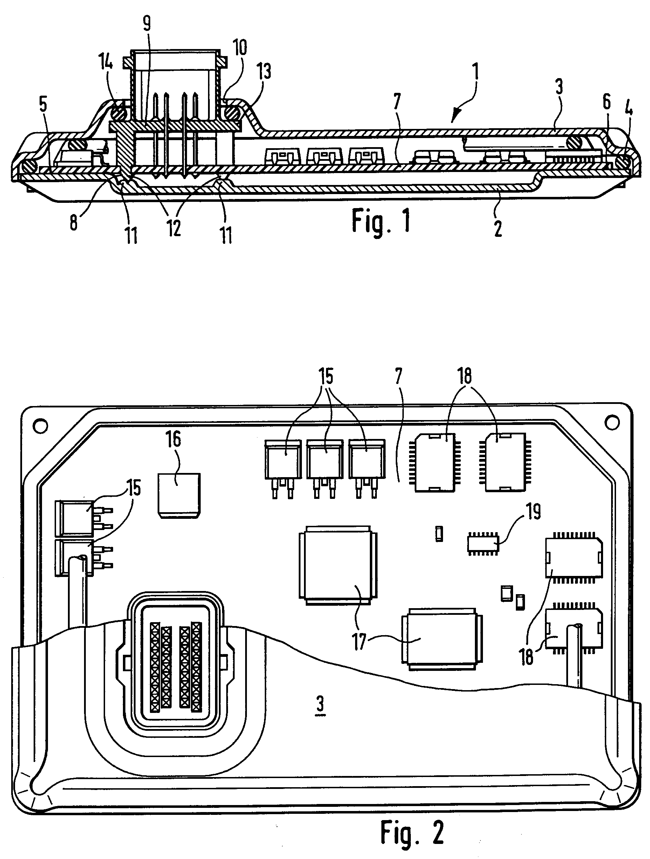

Ein Ausführungsbeispiel der Erfindung ist in der Zeichnung dargestellt und in der nachfolgenden Beschreibung näher erläutert. Es zeigen: Figur 1 eine Vorderansicht des Steuergerätes im Schnitt und Figur 2 eine Draufsicht auf das Steuergerät, zum Teil ohne Deckel.

### Beschreibung des Ausführungsbeispiels

Ein elektronisches Steuergerät hat ein Gehäuse 1, das aus zwei Halbschalen besteht, einem Boden 2 und einem Deckel 3. Der Deckel 3 ist an dem Boden 2 auf nicht näher dargestellte Weise festgeklipst und mit einer umlaufenden Dichtung 4 abgedichtet.

Am Boden 2 sind, dem Deckel 3 zugewandt, zwei Auflageflächen 5 und 6 vorgesehen, auf die eine Leiterplatte 7 aufgesetzt ist. Die Leiterplatte 7 ist durch nicht dargestellte Stifte ausgerichtet und nach ihrer Ausrichtung mit den Auflageflächen 5 und 6 verklebt. Auf diese Weise wird die Bestückungs- und Schaltungsfläche der Leiterplatte 7 nicht vermindert. Die gleiche Zielrichtung auf Nichtverminderung der Bestückungs- und Schaltungsfläche verfolgt auch eine Klipsverbindung 8 zwischen der Leiterplatte 7 und einer steckerartigen Messerleiste 9. Der Boden 2 ist unterhalb eines Deckel-Durchbruches 10 für die Messerleiste 9 mit einem angeformten Aufsetzdom 11 für Füße 12 versehen, die unten an der Messerleiste 9 vorgesehen sind.

Die Messerleiste 9 hat einen Flansch 13, auf den eine O-Ring-Dichtung 14 aufgesetzt ist. Diese O-Ring-Dichtung 14 ist zwischen dem Flansch 13 und der Unterseite des Deckels 3 eingespannt und drückt aufgrund ihrer Elastizität die Messerleiste 9 mit ihren Füßen 12 gegen den Aufsetzdom 11.

Die Leiterplatte 7 ist ein- oder beidseitig mit elektronischen Bausteinen 15, 16, 17, 18 und 19 bestückt. Insbesondere in der zum Teil geöffneten Darstellung nach Figur 2 ist zu erkennen, daß die Leiterplatte 7 eine große Nutzfläche hat und daß sie außer den Aufnahme- und Durchtrittsbohrungen für die Messerleiste 9 keine flächenverminderten Aussparungen oder Löcher aufweist. Dadurch und durch das Konzept des Gehäuses 1 ist eine maximale Bestückungs- und Schaltungsfläche geschaffen, die ein Optimum für die Leiterplatte 7 darstellt.

Die statische und dynamische Anbindung der Messerleiste 9 erfolgt zum einen dadurch, daß sich ein Anschlag und eine Aufnahme der Messerleiste 9 am Aufsetzdom 11 mit Hilfe der Klipsverbindung 8 ergibt und andererseits dadurch, daß über das kompressible und elastische Element, das die zwischen Messerleisten-Flansch 13 und Deckel 3 angeordnete O-Ring-Dichtung 14 darstellt, neben der reinen Abdichtung auch noch einen Toleranzausgleich und ein mechanisches Festhalten gegeben sind.

## Patentansprüche

1. Elektronisches Steuergerät mit einem Gehäuse (1) und mit einer von dem Gehäuse (1) umschlossenen Leiterplatte (7), die mit elektronischen Bausteinen (15 bis 19) bestückt ist, dadurch gekennzeichnet, daß das Gehäuse (1) aus zwei Halbschalen, einem Boden (2) und einem Deckel (3) besteht, daß die Leiterplatte (7) auf den Boden (2) aufgesetzt und an diesen fixiert ist und daß der Deckel (3) unter Zwischenlage einer umlaufenden Dichtung (4) auf den Boden (2) aufgesetzt ist.

2. Elektronisches Steuergerät nach Anspruch 1, dadurch gekennzeichnet, daß der Boden (2) innenliegende Auflageflächen (5 und 6) für die Leiterplatte (7) hat und daß die Leiterplatte (7) mit den Auflageflächen (5 und 6) verklebt ist.

3. Elektronisches Steuergerät nach Anspruch 1 oder 2, dadurch gekennzeichnet, daß eine steckerartige Messerleiste (9) mittels einer schraubenlosen Verbindung (8) auf der Leiterplatte (7) befestigt ist und den Deckel (3) an einem Deckel-Durchbruch (10) durchdringt.

4. Elektronisches Steuergerät nach Anspruch 3, dadurch gekennzeichnet, daß die schraubenlose Verbindung eine Klipsverbindung (8) ist.

5. Elektronisches Steuergerät nach Anspruch 3 oder 4, dadurch gekennzeichnet, daß der Boden (2) unter dem Deckel-Durchbruch (10) einen Aufsetzdom (11) für die Messerleiste (9) trägt.

6. Elektronisches Steuergerät nach einem der Ansprüche 3 bis 5, dadurch gekennzeichnet, daß der Deckel-Durchbruch (10) gegenüber der Messerleiste (9) mit einer auf einen Flansch (13) aufgesetzten, umlaufenden O-Ring-Dichtung (14) abgedichtet ist.

7. Elektronisches Steuergerät nach Anspruch 6, dadurch gekennzeichnet, daß bei aufgesetztem Deckel (3) die Elastizität der O-Ring-Dichtung (14) die Messerleiste (9) in Richtung des Aufsetzdomes (11) drückt.
